Europäisches Patentamt

European Patent Office

Office européen des brevets

(19)

(11) Veröffentlichungsnummer: **0 351 634 B1**

(12) # EUROPÄISCHE PATENTSCHRIFT

(45) Veröffentlichungstag der Patentschrift: **01.06.94**

(51) Int. Cl.⁵: **H03K 17/04**, H03K 19/094, H03K 19/013

(21) Anmeldenummer: **89112166.7**

(22) Anmeldetag: **04.07.89**

(54) Halbleiterschaltung für schnelle Schaltvorgänge.

(30) Priorität: **20.07.88 DE 3824694**

(43) Veröffentlichungstag der Anmeldung:
**24.01.90 Patentblatt  90/04**

(45) Bekanntmachung des Hinweises auf die
Patenterteilung:
**01.06.94 Patentblatt  94/22**

(84) Benannte Vertragsstaaten:
**FR GB IT NL**

(56) Entgegenhaltungen:
**EP-A- 0 093 086**
**DE-A- 3 709 383**
**US-A- 4 118 640**

**IBM TECHNICAL DISCLOSURE BULLETIN,
Band 14, Nr. 5, Oktober 1971, Seite 1592,
Armonk, NY, US; J. HONG et al.: "Nonsaturating logic circuit"**

(73) Patentinhaber: **TEMIC TELEFUNKEN microelectronic GmbH
Theresienstrasse 2
D-74072 Heilbronn(DE)**

(72) Erfinder: **Rothermel, Albrecht, Dipl.-Ing.
Düsseldorfer Strasse 106
D-4330 Mülheim 13(DE)**

(74) Vertreter: **Maute, Hans-Jürgen, Dipl.-Ing.
TEMIC TELEFUNKEN microelectronic GmbH
Postfach 35 35
D-74025 Heilbronn (DE)**

**Beschreibung**

Die Erfindung betrifft eine Logikschaltung wie sie aus Veröffentlichungen "CMOS/Bipolar-Logic "Nonsaturating Logic Circuit" in IBM Technical Disclosure Bulletin, Vol. 14, No. 5, 1971, S. 1592, bekannt ist. Bei dieser Schaltung werden wie üblich die Schaltsignale über einen Feldeffekttransistor zugeführt. Das heißt, die Ansteuerung mit dem Eingangssignal erfolgt an der Gate-Elektrode eines Feldeffekttransistors, dessen Drain- und Source-Elektroden mit einem Bipolartransistor verbunden sind. Zum Schalten eines solchen Anordnung ist ein Spannungshub von einigen Volt erforderlich. Diese Eigenschaft wirkt sich insbesondere dann störend aus, wenn der Eingang der Schaltung mit dem Ausgang eines umfangreichen Logiknetzwerkes, das eine große Kapazität aufweist, verbunden ist. Man erhält dann beim Schalten des Netzwerkes eine relativ langsame Flanke, d.h., der Übergang von 0 Volt bis zur vollen Betriebsspannung erfordert eine relativ lange Zeit.

In der digitalen Schaltungstechnik werden bipolare Transistoren vorteilhaft zum Schalten eingesetzt. Aufgrund ihrer großen Steilheit können sie bei kleinem Eingangsspannungshub einen großen Ausgangsstromhub liefern.

Das dynamische Verhalten bipolarer Transistoren ist durch die Änderung der gespeicherten Ladungen bestimmt.

Ein in Sättigung betriebener Transistor, der eine hohe gespeicherte Ladung in der Basis aufweist, zeigt ein verlangsamtes Schaltverhalten. Deshalb muß für schnelle Schaltvorgänge die Sättigung der Bipolartransistoren vermieden werden.

Bei sogenannten Schottky-Transistoren wird die Sättigung dadurch vermieden, daß parallel zur Basis-Kollektor-Sperrschicht eine Schottky-Diode geschaltet wird (R. Müller, "Bauelemente der Halbleiter-Elektronik", Springer-Verlag, 3. Auflage 1987, S. 249 ff).

Da Schottky-Dioden wesentlich geringere Schleusenspannungen als pn-Übergänge besitzen, fließt bei Parallelschaltung der Strom überwiegend durch die Schottky-Diode und nicht durch den Kollektor-Basis-Übergang des Bipolartransistors. Im Gegensatz zum p-n-Übergang im Transistor sind Schottky-Dioden Majoritätsträgerbauelemente, bei denen die Flußpolung zu keiner zusätzlichen Ladungsspeicherung führt, weshalb bei Parallelschaltung die Schaltgeschwindigkeit der Anordnung erhöht wird.

In der integrierten Schaltungstechnik erfordert die Herstellung von Schottky-Dioden zusätzliche Prozeßschritte. Dadurch erhöhen sich die Herstellungszeit und die Produktionskosten. Zur Strukturierung des Schottky-Kontaktes muß eine weitere Maske angefertigt werden. In den Prozeß muß ein zusätzliches Metall eingeführt werden, da das in den üblichen Integrations-Prozeß verwendete Aluminium für den Schottky-Kontakt nicht geeignet ist. Das Auftragen des Metalles erfordert eine Fotolackbeschichtung, eine Belichtung, eine Entwicklung, eine Lackätzung und eine Metallätzung. Die Wannendotierung muß für einen Schottky-Kontakt niedrig sein und genau kontrolliert werden. Da die Herstellung möglichst kleiner Strukturen eine hohe Dotierung erfordert, wirkt die Verwendung einer Schottky-Diode einer Strukturverkleinerung entgegen.

Aufgabe der Erfindung ist es, eine Halbleiterschaltung für schnelle Schaltvorgänge anzugeben, bei der die Sättigung von Bipolartransistoren sicher verhindert wird und die bei der Herstellung integrierter Schaltungen keine zusätzlichen Prozeßschritte erfordert.

Diese Aufgabe wird dadurch gelöst, daß das unidirektionale Halbleiterelement aus Feldeffekttransistoren zusammengesetzt ist.

Vorteilhafte Weiterbildungen der Erfindung sind in den Unteransprüchen gekennzeichnet.

Nach Anspruch 2 besteht das unidirektionale Halbleiterelement aus zwei Feldeffekttransistoren. Sie sind so geschaltet, daß der Strom aus der Stromquelle Ib bei kleiner Kollektor-Emitter-Spannung (z.B. 0,4 Volt) des Bipolartransistors 3 über den Feldeffekttransistor 2 abfließt, wodurch der Basisstrom reduziert wird und der Bipolartransistor nicht in den Zustand der Sättigung treten kann.

Da die wesentliche Aufgabe des zweiten Feldeffekttransistors 1, der als Diode geschaltet ist, darin besteht, dem ersten Feldeffekttransistor 2 eine konstante Steuerspannung zur Verfügung zu stellen, kann er nach Anspruch 3 durch eine konstante Referenzspannungsquelle ersetzt werden. Diese Weiterbildung der Schaltung bietet den Vorteil, daß sie mit geringerer Chipfläche auskommt.

Nach Anspruch 4 dient die hybride Transistorschaltung als Leseverstärker für ein Logiknetzwerk mit den Eingängen A bis F, das beispielsweise durch die Feldeffekttransistoren 8 bis 13 gebildet wird. Bereits eine kleine Spannungsänderung in diesen Transistoren reicht aus, um die Anordnung zu schalten. Da die kleine Spannungsänderung schnell ereicht ist, findet der Schaltvorgang sehr rasch statt.

Die erfindungsgemäße Halbleiterschlatung kann vorteilhaft in der schnellen digitalen Schaltungstechnik mit bipolaren Transistoren und Feldeffekttransistoren eingesetzt werden.

Da keine Schottky-Dioden benötigt werden, fallen zusätzliche Prozeßschritte bei der Herstellung der Schaltung weg. Trotzdem wird eine Sättigung der Bipolartransistoren sicher vermieden, wodurch eine hohe Schaltgeschwindigkeit gewährleistet ist.

Aufgrund der großen Steilheit der Schaltung, die durch den Bipolartransistor 3 bestimmt wird, ist nur ein kleiner Spannungshub des Eingangssignales zum Schalten notwendig. Durch die Diodencharakteristik des Bipolartransistors zwischen seinem Basis- und Emitteranschluß ergibt sich eine automatische Begrenzung des Eingangssignal-Hubes auf den Bereich zwischen 0 Volt und 0,7 Volt. Auf der Ausgangsseite liefert die Schaltung einen hohen Stromhub und kann damit weitere Schaltungen mit großer Kapazität speisen. Da die Anordnung der Feldeffekttransistoren 1 und 2 einen Stromspiegel darstellt, ist sie unabhängig von jeglichen absoluten Schwankungen der Bauteile-Eigenschaften. Die beiden Transistoren müssen nur relativ zueinander die gleichen Eigenschaften aufweisen.

Drei Ausführungsbeispiele der Halbleiterschaltung sind in den Zeichnungen dargestellt und werden im folgenden näher beschrieben.

Es zeigen:

Fig. 1    Schaltung zur Vermeidung der Sättigung von Bipolartransistoren;

Fig. 2    Schaltung mit nachgeschaltetem zweiten Bipolartransistor und

Fig. 3    Anwendung der Schaltung als Leseverstärker für ein Logiknetzwerk.

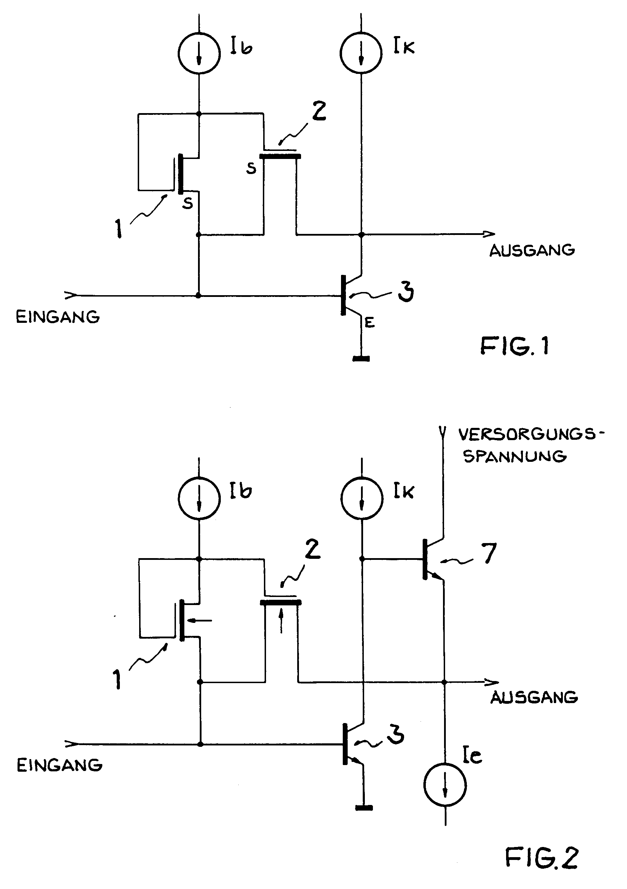

Die Schaltung in Fig. 1 besteht aus einem npn-Bipolartransitor 3 und zwei n-Kanal Feldeffekttransistoren 1 und 2. Die Stromversorgung ist mit Ik für die Kollektorstromquelle und mit Ib für die Basisstromquelle bezeichnet.

Der Feldeffekttransistor 2 ist mit der Source- und Drainelektrode an Kollektor- und Basiselektrode des Bipolartransistors 3 angeschlossen. Wenn der Bipolartransistor 3 sperrt, fließt durch den Transistor 2 ein zusätzlicher Basisstrom, so daß der gesamte Strom, der über den Eingangsanschluß fließt, größer als Ib ist. Wird der Eingang anschließend hochohmig, beginnt der Transistor 3 durchzuschalten. Dabei nimmt die Kollektorspannung ab. Solange die Kollektor-Basis-Spannung größer ist als die effektive Gate-Spannung des Transistors 2, bleibt der Basisstrom etwa konstant. Wenn sich nun die Kollektorspannung soweit verringert, daß sich die Kollektor-Basis-Spannung umkehrt, beginnt ein Teil des Stromes Ib über den Transistor 2 und die Kollektor-Emitter-Strecke des Bipolartransistors 3 zu fließen. Dadurch verringert sich der Basisstrom des Transistors 3 nicht nur auf Ib sondern er wird noch kleiner. Bei richtiger Dimensionierung kann so die Sättigung völlig verhindert werden. Der als Diode geschaltete Feldeffekttransistor 1 liefert eine konstante Steuerspannung für den Transistor 2.

Bei der Halbleiterschaltung in Fig. 2 ist zwischen der Kollektorelektrode des Bipolartransistors 3 und der Drainelektrode des Feldeffekttransistors 2 ein zusätzlicher Bipolartransistor 7 geschaltet. Seine Emitter-Stromversorgung ist mit Ie bezeichnet. Diese Variante ist vorteilhaft, wenn der Ausgang hohe Ströme liefern soll, um beispielsweise eine hohe Kapazität treiben zu können. Die übrigen Eigenschaften der ursprünglichen Schaltung bleiben erhalten.

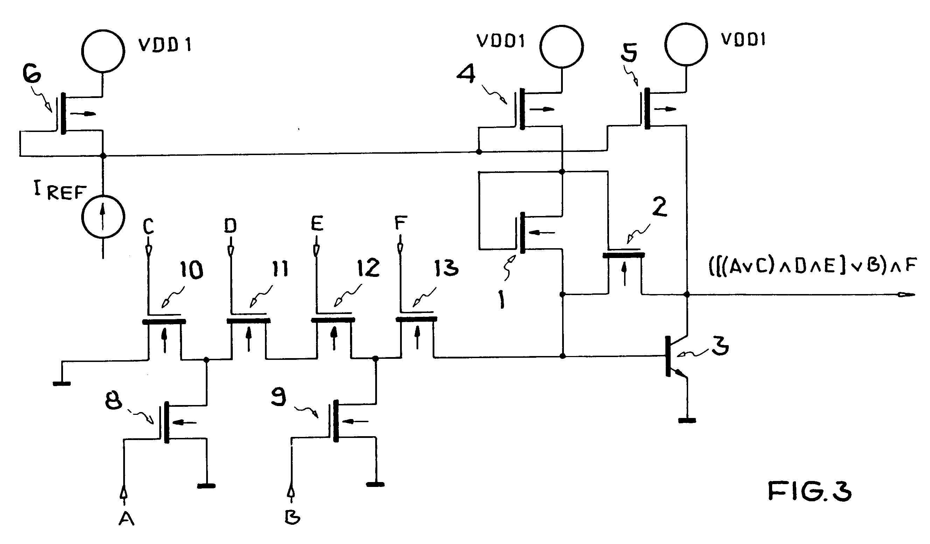

In Fig. 3 dient die erfindungsgemäße Schaltung als Leseverstärker für ein Logiknetzwerk, das aus den Feldeffekttransistoren 8 bis 13 aufgebaut ist. Die Eingänge sind mit A bis F bezeichnet. Das Logiknetzwerk realisiert die Funktion:

$$(((A \vee C) \wedge D \wedge E) \vee B) \wedge F.$$

Durch die Anordnung der Transistoren 1 bis 3 bleibt der Spannungshub im Logiknetzwerk auf eine Diodendurchlaßspannung (0,7 V) begrenzt, wodurch eine hohe Schaltgeschwindigkeit erreicht wird.

Die p-Kanal Feldtransistoren 4, 5 und 6 dienen der Einstellung des Basis- und des Kollektorstromes des Bipolartransistors 3. Dabei bestimmt der Transistor 6 die absolute Größe der Summe aus Kollektor- und Basisstrom und die Transistoren 4 und 5 das Verhältnis von Kollektor- zu Basisstrom. Die Spannungsversorgung dieser Transistoren erfolgt über die Betriebsspannung VDD1, für die Konstanz der Stromversorgung sorgt die Referenzstromquelle IREF.

Für eine optimale Sättigungsvermeidung wurden folgende Dimensionen für die Kanäle der Feldeffekttransistoren ermittelt:

| Transistoren 1 und 2 | Kanalweite | 30 $\mu$m, |
| | Kanallänge | 2,5 $\mu$m; |
| Transistor 4 | Kanalweite | 25 $\mu$m, |
| | Kanallänge | 2,5 $\mu$m; |
| Transistor 5 | Kanalweite | 150 $\mu$m, |
| | Kanallänge | 2,5 $\mu$m. |

Es sei ausdrücklich darauf hingewiesen, daß diese Maßangaben für ein spezielles Ausführungsbeispiel gelten und keine Einschränkung darstellen. Auch andere Zahlenverhältnisse können zu einer optimalen Sättigungsvermeidung führen.

Für die Herstellung der erfindungsgemäßen Schaltung eignen sich besonders die Verfahren der BICMOS-Technologie, die die monolithische Integration von Bipolar- und MOS-Transistoren ermöglichen.

**Patentansprüche**

1. Integrierte Halbleiterschaltung mit einem Eingang, einem in Emitterschaltung betriebenen Bipolartransistor (3) und einem Ausgang, wobei der Ausgang mit dem Kollektor des Bipolartransistors gekoppelt ist und zwischen dem Ausgang und der Basiselektrode des Bipolartransistors (3) die Source-Drain-Strecke eines Feldeffekttransistors (2) geschaltet ist, dadurch gekennzeichnet, daß der Eingang direkt mit der Basiselektrode des Bipolartransistors (3) verbunden ist und daß an dem Feldeffekttransistor (2) eine konstante Gate-Sourcespannung anliegt.

2. Integrierte Halbleiterschaltung nach Anspruch 1, dadurch gekennzeichnet, daß die konstante Steuerspannung an dem Feldeffekttransistor (2) mittels eines zweiten Feldeffekttransistors (1) erzeugt wird, indem die beiden Source-Elektroden der beiden Feldeffekttransistoren mit der Basiselektrode des Bipolartransistors (3) verbunden sind, die Gate-Elektrode und die Drain-Elektrode des zweiten Feldeffekttranistors (1) kurzgeschlossen und leitend sowohl mit der Gatelektrode des ersten Feldeffekttransistors (2) als auch mit einer Konstantstromquelle (IB) verbunden sind und am Kollektor des Bipolartransistors (3) eine zweite Stromquelle (IK) angeschlossen ist.

3. Integrierte Halbleiterschaltung nach Anspruch 2 dadurch gekennzeichnet, daß der zweite Feldeffekttransistor (1) durch eine konstante Referenzspannungsquelle ersetzt ist.

4. Integrierte Halbleiterschaltung nach einem der vorangehenden Ansprüche, dadurch gekennzeichnet, daß die Schaltung als Leseverstärker eines komplexen Logiknetzwerks dient.

5. Integrierte Halbleiterschaltung nach einem der vorangehenden Ansprüche dadurch gekennzeichnet, daß der erste (2) und der zweite (1) Feldeffekttransistor als n-Kanaltransistor und der Bipolartransistor (3) als npn-Transistor ausgebildet ist.

**Claims**

1. An integrated semiconductor circuit with an input, a bipolar transistor (3) operated in the emitter circuit and an output, wherein the output is coupled with the collector of the bipolar transistor and the source-drain link of a field effect transistor (2) is connected between the output and the base electrode of the bipolar transistor (3), characterised in that the input is directly connected to the base electrode of the bipolar transistor (3), and that a constant gate-source voltage is applied to the field effect transistor (2).

2. An integrated semiconductor circuit according to claim 1, characterised in that the constant control voltage is generated at the field effect transistor (2) by means of a second field effect transistor (1), through the two source electrodes of the two field effect transistors being connected to the base electrode of the bipolar transistor (3), the gate electrode and the drain electrode of the second field effect transistor (1) being short-circuited and conductively connected both to the gate electrode of the first field effect transistor (2) and to a constant current source (IB), and a second current source (IK) being connected to the collector of the bipolar transistor (3).

EP 0 351 634 B1

3. An integrated semiconductor circuit according to claim 2, characterised in that the second field effect transistor (1) is replaced by a constant reference voltage source.

4. An integrated semiconductor circuit according to any of the preceding claims, characterised in that the circuit is used as a reading amplifier of a complex logic network.

5. An integrated semiconductor circuit according to any of the preceding claims, characterised in that the first (2) and second (1) field effect transistors are in the form of n-channel transistors, and the bipolar transistor (3) is in the form of an npn transistor.

**Revendications**

1. Circuit semi-conducteur intégré possédant une entrée, un transistor bipolaire (3) utilisé dans un montage à émetteur commun, ainsi qu'une sortie, dans lequel la sortie est couplée au collecteur du transistor bipolaire et le circuit source-drain d'un transistor à effet de champ (2) est connecté entre la sortie et l'électrode de base du transistor bipolaire (3), caractérisé en ce que l'entrée est reliée directement à l'électrode de base du transistor bipolaire (3) et qu'une tension grille-source constante est appliquée au transistor à effet de champ (2).

2. Circuit semi-conducteur intégré selon la revendication 1, caractérisé en ce que la tension de commande constante sur le transistor à effet de champ (2) est générée au moyen d'un second transistor à effet de champ (1), du fait que les deux électrodes de source des deux transistors à effet de champ sont reliées à l'électrode de base du transistor bipolaire (3), l'électrode de grille et l'électrode de drain du second transistor à effet de champ (1) sont court-circuitées et connectées à la fois à l'électrode de grille du premier transistor à effet de champ (2) et à une source de courant constant (IB), et une seconde source de courant (IK) est raccordée au collecteur du transistor bipolaire (3).

3. Circuit semi-conducteur intégré selon la revendication 2, caractérisé en ce que le second transistor à effet de champ (1) est remplacé par une source de tension de référence constante.

4. Circuit semi-conducteur intégré selon une des revendications précédentes, caractérisé en ce que le circuit sert d'amplificateur de lecture d'un réseau logique complexe.

5. Circuit semi-conducteur intégré selon une des revendications précédentes, caractérisé en ce que le premier (2) et le second transistor à effet de champ (1) sont des transistors à canal n et le transistor bipolaire (3) est un transistor npn.

5

FIG.1

FIG.2

FIG.3

VDD1

(([(A∨C)∧D∧E]∨B)∧F

5  4  2  1  13  12  11  10  3  9  8  6

VDD1

VDD1

F  E  D  C  B  A

I REF